Europäisches Patentamt

European Patent Office

Office européen des brevets

(19)

(11) Veröffentlichungsnummer : **0 041 684**
**B1**

(12)

# EUROPÄISCHE PATENTSCHRIFT

(45) Veröffentlichungstag der Patentschrift :
05.06.85

(51) Int. Cl.⁴ : **H 01 L 21/56, H 01 L 21/31**

(21) Anmeldenummer : **81104220.9**

(22) Anmeldetag : **02.06.81**

(54) **Verfahren zur Vorbereitung einer anschliessenden Kontaktierung von mit einer Aluminisierung versehenen Siliciumbauelementen.**

(30) Priorität : 04.06.80 DE 3021175

(43) Veröffentlichungstag der Anmeldung :
16.12.81 Patentblatt 81/50

(45) Bekanntmachung des Hinweises auf die Patenterteilung : 05.06.85 Patentblatt 85/23

(84) Benannte Vertragsstaaten :
FR GB IT

(56) Entgegenhaltungen :
EP-A- 0 000 480
FR-A- 2 382 095
IBM TECHNICAL DISCLOSURE BULLETIN, Band 21, nr.12, 1979, New York (US), J.J. GAJDA et al. "Selective conversion of films to facilitate delineation", Seiten 4848-4851

(73) Patentinhaber : **Siemens Aktiengesellschaft Berlin und München Wittelsbacherplatz 2 D-8000 München 2 (DE)**

(72) Erfinder : **Dathe, Joachim, Dipl.-Phys. Schleissheimer Strasse 276/6 D-8000 München 40 (DE)**

**Beschreibung**

Die Erfindung betrifft ein Verfahren zur Vorbereitung einer anschließenden Kontaktierung von mit einer Aluminisierung versehenen Siliciumbauelementen, bei denen mindestens eine Siliciumschicht auf der Aluminisierung abgeschieden ist und bei denen eine Temperung vorgesehen ist.

Zur Stabilisierung der Strom-Spannungskennlinien von Halbleiterbauelementen ist bekannt, die Oberflächen der Bauelemente dadurch zu passivieren, daß verschiedene organische oder anorganische Deckschichten aufgetragen werden. Mittels solcher, beispielsweise aus Lacken, Kautschuken oder Gläsern bestehenden Deckschichten läßt sich im allgemeinen eine ausreichende Stabilität der Kennlinien erreichen. Gelegentlich treten jedoch Instabilitäten auf, deren Ursachen in Änderungen der Eigenschaften der Deckschicht und/oder der Bauelementoberfläche zu suchen sind und die zu starken Schwankungen in der Ausbeute an brauchbaren Bauelementen führen können.

Es ist auch bereits beschrieben worden, ein Halbleiterelement dadurch zu passivieren, daß man eine Siliciumschicht thermisch aufwachsen läßt. Dieses Verfahren ist jedoch relativ zeitraubend und aufwendig. Es erfordert außerdem hohe Temperaturen.

Aus der DE-OS 26 32 647 ist ein Passivierungsverfahren bekannt, bei dem die Schutzschicht aus aufgedampftem Silicium besteht. Dadurch wird eine Kennlinienstabilisierung mit wesentlich weniger Aufwand erreicht. Aus der DE-OS 27 30 367 ist zusätzlich bekannt, daß bei Passivierung mittels einer aufgedampften Siliciumschicht sich der Sperrstrom in Sperrrichtung und der Sperrstrom in Kipprichtung eines Halbleiterelementes durch einen Temperprozeß drastisch absenken läßt. Besonders günstige Ergebnisse lassen sich dabei erzielen, wenn in sauerstoffhaltiger Atmosphäre getempert wird.

Das aus der DE-OS 26 32 647 und der DE-OS 27 30 367 bekannten Passivierungsverfahren wird üblicherweise als EPOS-Verfahren (Evaporated Polysilicon on Surface) bezeichnet. Eine nach diesem Verfahren aufgedampfte Polykristalline Siliciumschicht wird daher im folgenden kurz mit « EPOS » bezeichnet.

Wird diese Siliciumschicht auf eine bereits mit einer Metallisierung versehene Siliciumscheibe gedampft, so sind jedoch technologische Maßnahmen notwendig, um die Bauelemente an den Kontaktierbereichen vom aufgedampften Silicium zu befreien bzw. kontaktierbar zu machen. Dies geschieht in der Regel dadurch, daß die Kontaktierbereiche der zu bedampfenden Bauelemente durch Maskierung, beispielsweise mittels Fotolack oder einer Lochmaske geschützt werden oder daß die Kontaktierbereiche nach der Bedampfung durch selektives Ätzen von der EPOS-Schicht befreit werden. Entsprechende Maßnahmen sind jedoch nicht unproblematisch.

Fertigungstechnisch ist z. B. insbesondere die fotolackmaskierte selektive Ätzung der Passivierungsschicht von Bedeutung. Dabei können aber wegen Maskierungsproblemen an Mesakanten und durch Angriff der Metalloberfläche erhebliche Störungen der Passivierung bzw. der nachfolgenden Kontaktierung auftreten.

Diese Probleme können dadurch vermieden werden, daß bereits aufgelötete und kontaktierte Chips passiviert werden, so daß keine Maskierung oder kein selektives Ätzen erforderlich ist. Ein solches Vorgehen ist jedoch insbesondere bei kleinen Chipgrößen relativ kostspielig. Auch kann die Passivierung durch von den Kontaktierungsdrähten verursachte Maskierungseffekte beeinflußt werden.

Aufgabe der Erfindung ist es, ein kostengünstig durchführbares Verfahren zur Vorbereitung einer anschließenden Kontaktierung von mit Aluminiummetallisierungen versehenen Siliciumbauelementen, bei denen mindestens eine Siliciumschicht auf den Aluminiummetallisierungen abgeschieden ist, anzugeben, bei dem keine Maskierungs- oder Ätzmaßnahmen notwendig sind, um die Bauelemente an den Kontaktierbereichen von Silicium zu befreien.

Diese Aufgabe wird erfindungsgemäß dadurch gelöst, daß die Bauelemente nach dem Aufbringen der Siliciumschicht bei einer Siliciumschichtdicke von mehr als 0,1 $\mu$m bei einer Temperatur von 480 bis 570 °C, bei einer Siliciumschichtdicke bis 0,1 $\mu$m bei einer Temperatur von 400 bis 500 °C getempert werden und bei einer Siliciumschichtdicke von weniger als 0,05 $\mu$m der Temperprozeß entfällt. Durch den Temperprozeß diffundiert das auf der zu kontaktierenden Aluminiumschicht befindliche aufgedampfte Silicium in diese hinein, so daß eine kontaktierfähige Oberfläche erhalten wird. Das Verfahren läßt sich bei Dioden, Transistoren, Thyristoren oder anderen Siliciumbauelementen anwenden.

Vorzugsweise wird das Verfahren so durchgeführt, daß die Bauelemente mit einer Siliciumschichtdicke von mehr als 0,1 $\mu$m bei einer Temperatur von 500 bis 550 °C getempert werden, daß die Bauelemente bei einer Siliciumschichtdicke bis 0,1 $\mu$m bei einer Temperatur von 420 bis 480 °C getempert werden, daß die Temperzeit im Bereich zwischen 10 Minuten und 2 Stunden eingestellt wird und daß der Temperprozeß in inerter oder reduzierender Atmosphäre durchgeführt wird.

Es liegt im Rahmen der Erfindung, daß die Siliciumschicht durch Aufdampfen oder Aufsputtern aufgebracht wird und daß eine polykristalline Siliciumschicht aufgebracht wird.

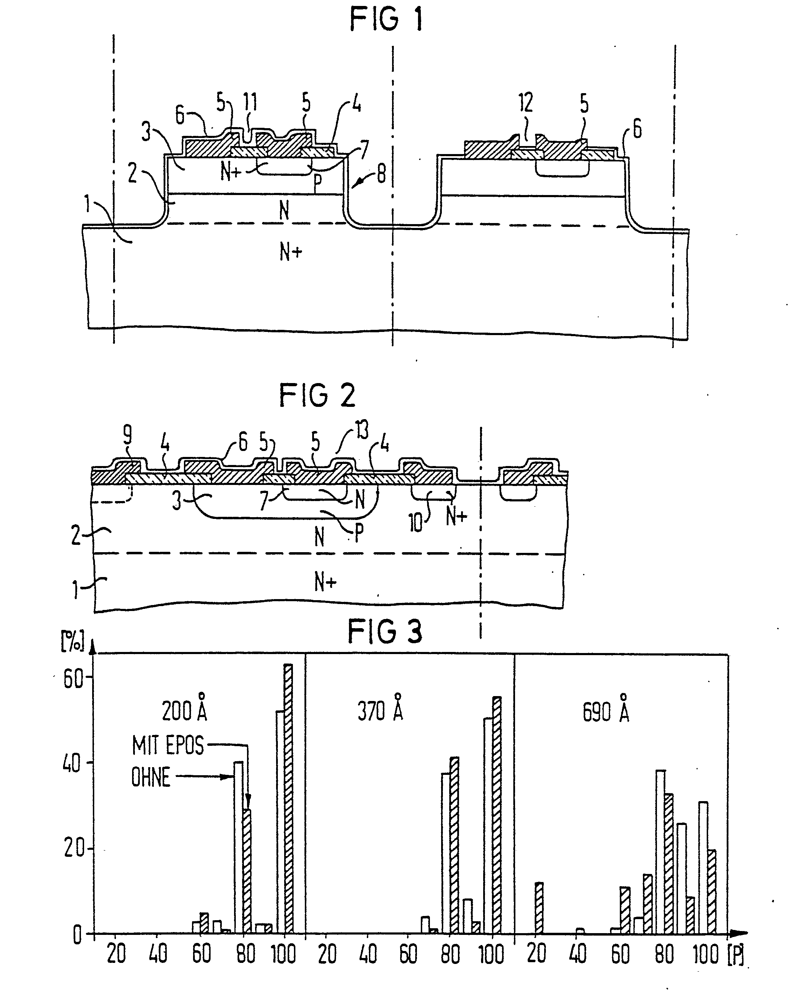

Die Erfindung wird im folgenden anhand der Figuren näher erläutert. Die Fig. 1 zeigt ausschnittsweise einen Schnitt durch eine Mesastrukturen aufweisende, mittels des erfindungsgemäßen Verfahrens passivierte Siliciumscheibe.

Die Fig. 2 zeigt eine entsprechende, planare Strukturen aufweisende Siliciumscheibe. In der Fig. 3 werden die sogenannten Nailhead-Abscherkräfte mit und ohne durchgeführtes EPOS-Verfahren für unterschiedliche Schicht ohne Temperung verglichen.

Als Beispiel für ein Siliciumbauelement mit Mesastrukturen ist in der Fig. 1 ein NPN-Epibasistransistor mit EPOS dargestellt. Der linke Teil der Fig. 1 zeigt einen Transistor 11 nach der Bedampfung aber vor der Temperung, während der rechte Teil der Fig. 1 einen Transistor 12 nach der Temperung zeigt. Die gezeigten Transistoren 11, 12 bestehen aus einem $N^+$-Substrat 1 und über dem Substrat 1 abgeschiedenen unterschiedlich dotierten Schichten 2, 3 und 7, wobei die N-Schicht 2 den Kollektor, die P-Schicht 3 die Basis und die $N^+$-Schicht 7 den Emitter des NPN-Epibasistransistors darstellen. Der pn-Übergang zwischen Basis 3 und Emitter 7 ist an der Scheibenoberfläche durch eine Oxidschicht 4, beispielsweise aus $SiO_2$ abgedeckt. Basis 3 und Emitter 7 sind jeweils mittels Aluminiumschichten 5 kontaktiert. Die Siliciumschicht EPOS 6 von etwa 0,1 bis 0,4 μm Dicke wird auf die gesamte Oberfläche und damit auch auf den an der Mesakante 8 an die Oberfläche tretenden pn-Übergang direkt insbesondere durch Aufdampfen aufgebracht. Dabei werden auch die Aluminiumkontakte 5, die üblicherweise eine Dicke von 0,8 bis 6 μm aufweisen, überdeckt. In diesem Zustand sind die Bauelemente nicht kontaktierfähig, auch nicht mittels eines Golddraht-Thermokompressionsverfahrens oder eines Aluminiumdraht-Ultraschall-Bonding-Verfahrens.

Es hat sich nun überraschenderweise gezeigt, daß bei einer Temperung der Scheiben in einem Temperaturbereich zwischen 480 bis 570 °C, insbesondere 500 bis 550 °C (im folgenden EPOS-Temperung genannt) das auf der Aluminiumschicht befindliche Silicium in die Aluminiumschicht hineindiffundiert und somit eine kontaktierfähige Oberfläche erhalten wird. Hierbei ist es unerheblich, ob das Aluminium bereits in einem vorhergehenden Schritt einlegiert bzw. angesintert worden ist, oder ob ein solcher Verfahrensschritt gleichzeitig mit der EPOS-Temperung durchgeführt wird.

Dieser Diffusionsvorgang ist insbesondere deshalb überraschend, da sich gezeigt hat, daß erheblich mehr Silicium im Aluminium gelöst werden kann, als nach dem bekannten Phasendiagramm zu erwarten ist und daß trotzdem die Härteverhältnisse u. ä. nicht so ungünstig sind, daß eine Draht-Kontaktierung des Aluminiums verhindert wird. Ferner hat es sich gezeigt, daß polykristallines Silicium besser diffundiert als monokristallines Silicium. Wird die Temperatur bei EPOS-Dicken von mehr als 0,1 μm niedriger als dem angegebenen entsprechenden Bereich gewählt, so ist keine ausreichende Diffusion des Siliciums mehr gegeben. Bei Temperaturen, die über dem angegebenen Bereich liegen, kommt es zu seitlichen Aluminiumausscheidungen im Silicium, so daß insbesondere bei schmalen Spalten zwischen zwei Aluminiummetallisierungen die Gefahr des Auftretens von Kurzschlüssen gegeben ist.

Der im rechten Teil der Fig. 1 gezeigte Transistor 12 zeigt den Zustand des EPOS 6 und der kontaktierfähigen Aluminiummetallisierung 5 nach der Temperung. Die Temperung kann entweder in einer inerten Atmosphäre, beispielsweise in Argon, oder in einer reduzierenden Atmosphäre, beispielsweise einem aus Stickstoff und 3 bis 10 % Wasserstoff bestehendem Formiergas, durchgeführt werden. Eine oxydierende Atmosphäre ist ungünstig, da dann Oxidschichten ($SiO_2$, $Al_2O_3$) entstehen, die eine Eindiffusion von Silicium in Aluminium behindern. Die Verwendung einer wasserstoffhaltigen Atmosphäre hat den Vorteil, daß die $SiO_2$-Si-Grenzflächeneigenschaften der Bauelemente nicht negativ beeinflußt werden, falls derartige Bereiche, wie in der Fig. 1 gezeigt, vorhanden sind.

Die Kontaktierfähigkeit der Aluminiumoberflächen läßt sich z. B. durch Messung der Lichtreflexion bedampfter und unbedampfter Aluminiumoberflächen bestimmen. Oberflächen mit hohem Reflexionsgrad sind in der Regel kontaktierbar.

Erfahrungsgemäß ist die Kontaktierbarkeit dann gewährleistet, wenn der Reflexionsfaktor der bedampften Aluminium-Oberfläche nach Temperung 90 % der unbedampften Oberfläche beträgt.

Die Fig. 2 zeigt einen Schnitt durch einen NPN-Planartransistor 13 mit EPOS 6 ohne durchgeführte EPOS-Temperung. Der Transistor 13 besteht aus über den $N^+$-Substrat 1 angeordneter N-Kollektorschicht 2, P-dotierter Basis 3 und N-dotiertem Emitter 7. Die pn-Übergänge zwischen Emitter 7 und Basis 3 bzw. zwischen Basis 3 und Kollektor 2 sind an der Oberfläche durch eine $SiO_2$ bzw. eine $SiO_2/Si_3N_4$-Schicht 4 bedeckt. Basis 3, Emitter 7 und beispielsweise ein zusätzlich angeordneter $N^+$-Channelstopper 10 sind mit Aluminiumschichten 5 bedeckt. Die Aluminiumschichten 5 haben üblicherweise eine Dicke von 0,8 bis 2 μm. Zur Abschirmung bzw. Kompensation von Oberflächenladungen wird der Planartransistor 13 mit einer EPOS-Schicht 6 versehen. Um die Kontaktierfähigkeit der Aluminiumoberflächen zur ermöglichen muß bei EPOS-Dicken von mehr als 0,05 μm Dicke ebenfalls eine EPOS-Temperung durchgeführt werden. Der Temperaturbereich für den Temperprozeß beträgt bei Schichtdicken von nicht mehr als 0,1 μm 400 bis 500 °C, insbesondere 420 bis 480 °C. Die Temperzeit wird unabhängig von der Schichtdicke vorteilhafterweise zwischen 10 Minuten und 2 Stunden gewählt, da bei Wahl einer kleineren Zeit die diffundierte Siliciummenge zu gering ist und bei größeren Zeiten sich sonst der Stabilisierungseffekt der EPOS-Schicht verschlechtern kann. Lange Temperzeiten sind ferner unwirtschaftlich. Die Wahl der Temperatmosphäre ist ebenfalls unabhängig von der EPOS-Dicke.

Bei Bauelementen mit feinen Aluminiumstrukturen, beispielsweise HF-Transistoren, beziehungsweise bei Bauelementen mit geringen Abständen zwischen den Aluminium-Leiterbahnen können durch die EPOS-Temperung wegen der unvermeidlichen seitlichen Aluminium-Silicium-Diffusion Kurzschlüsse entstehen. Dem kann durch Verringerung der EPOS-Dicke abgeholfen werden. Es hat sich nun überraschenderweise gezeigt, daß bei einer Verringerung der EPOS-Dicke auf weniger als 0,05 μm eine EPOS-Temperung zur Eindiffusion des Siliciums in das Aluminium nicht mehr notwendig ist. Die Bauelemente sind auch ohne zusätzliche EPOS-Temperung kontaktierfähig.

In der Fig. 3 werden die sogenannten Nailhead-Abscherkräfte von ungetemperten Siliciumscheiben mit und ohne EPOS bei EPOS-Dicken von 200, 370 und 690 Å verglichen, wobei eine Golddraht-Kontaktierungs-Technologie zur Anwendung kam. Unter Nailhead-Abscherkräften versteht man die Kräfte, die senkrecht auf einen an einer Metallisierung angebrachten Kontaktdrahtkopf mindestens wirken müssen, um den Draht von der Metallisierung zu trennen. In der Fig. 3 sind drei Diagramme für EPOS-Schichtdicken von 200, 370 und 690 Å gezeigt, auf deren Abszisse die Größe der Nailhead-Abschiebekräfte in Pond und auf deren Ordinate die Prozentzahl der bei der entsprechenden Abschiebekraft von der Metallisierung getrennten kontaktierenden Anschlüsse angibt. Die unausgefüllten Balken geben die entsprechende Prozentzahl für Bauelemente ohne EPOS-Schicht und die ausgefüllten Balken die entsprechenden Bauelemente mit EPOS-Schicht an. Eine Nailhead-Abschiebekraft von weniger als 50 Pond (1 Pond = 9,81 · 10⁻³Newton) wird üblicherweise als ungenügend betrachtet. Aus der Fig. 3 ist zu erkennen, daß erst bei einer EPOS-Dicke von mehr als 0,05 μm (690 Å) zum Teil schlechte Haftung auftritt, eine EPOS-Temperung bei geringen Schichtdicken daher nicht unbedingt notwendig ist. Bei Anwendung anderer Kontaktierungs-Technologien, z. B. Aluminiumdraht-Ultraschall-Bonding, kann eine EPOS-Temperung zur Verbesserung der Kontaktierung jedoch vorteilhaft sein. Ein Einfluß der Schichtdicken auf die Passivierungseigenschaften bezüglich Oberflächenionen konnte nicht festgestellt werden. Vorteilhaft wirkt sich die geringe Schichtdicke von insbesondere 0,04 μm auf den parasitären Stromfluß zwischen Emitter-Basis-Elektroden 5 bzw. Basis-Äquipotentialflächen-Elektroden 5, 9 aus.

Durch den Entfall der Temperung sind die Aluminiumkanten gut mit Silicium bedeckt, was im Feuchtetest zu besserer Korrosionsbeständigkeit führt. Die Kratzfestigkeit der Aluminiumoberfläche wird ebenfalls verbessert. EPOS-Dicken von weniger als 0,05 μm lassen sich nur mit aufgedampften Silicium herstellen. Es kann beispielsweise, wie in der DE-OS 27 30 367 beschrieben, eine herkömmliche Vakuum-Bedampfungsanlage mit einem Siliciumklotz als Siliciumquelle verwendet werden.

Als Energiequelle kann ein Elektronenstrahl zum Einsatz kommen. Die in der DE-OS 27 30 367 beschriebene Stabilisierungstemperung bei beispielsweise 280 °C kann gegebenenfalls nach dem erfindungsgemäßen Temperprozeß durchgeführt werden.

Das erfindungsgemäße Verfahren hat den Vorteil, daß einerseits die Strom-Spannungskennlinien von Bauelementen stabilisiert werden, andererseits die Durchbruchspannung der Bauelemente erhöht wird und bei Verwendung von noch nicht kontaktierten Bauelementen ein mit Nachteilen verbundener Ätz- oder Maskierungsschritt eingespart wird.

**Patentansprüche**

1. Verfahren zur Vorbereitung einer anschließenden Kontaktierung von mit einer Aluminisierung versehenen Siliciumbauelementen, bei denen mindestens eine Siliciumschicht auf der Aluminisierung abgeschieden ist und bei denen eine Temperung vergesehen ist, dadurch gekennzeichnet, daß die Bauelemente nach dem Aufbringen der Siliciumschicht bei einer Siliciumschichtdicke von mehr als 0,1 μm bei einer Temperatur von 480 °C bis 570 °C, bei einer Siliciumschichtdicke bis 0,1 μm bei einer Temperatur von 400 °C bis 500 °C getempert werden und bei einer Siliciumschichtdicke von weniger als 0,05 μm der Temperprozeß entfällt.

2. Verfahren nach Anspruch 1, dadurch gekennzeichnet, daß die Bauelemente bei einer Schichtdicke von mehr als 0,1 μm bei einer Temperatur von 500 bis 550 °C getempert werden.

3. Verfahren nach Anspruch 1 oder 2, dadurch gekennzeichnet, das die Bauelemente bei einer Schichtdicke bis 0,1 μm bei einer Temperatur von 420 bis 480 °C getempert werden.

4. Verfahren nach einem der Ansprüche 1 bis 3, dadurch gekennzeichnet, daß die Temperzeit im Bereich zwischen 10 Minuten und 2 Stunden eingestellt wird.

5. Verfahren nach einem der Ansprüche 1 bis 4, dadurch gekennzeichnet, daß der Temperprozeß in inerter oder reduzierender Atmosphäre durchgeführt wird.

6. Verfahren nach einem der Ansprüche 1 bis 5, dadurch gekennzeichnet, daß die Siliciumschicht durch Aufdampfen oder Aufsputtern aufgebracht wird.

7. Verfahren nach einem der Ansprüche 1 bis 6, dadurch gekennzeichnet, daß eine polykristalline Siliciumschicht aufgebracht wird.

**Claims**

1. A method of preparing for the subsequent contacting of silicon components provided with an aluminium layer, in which at least one silicon layer is deposited on the aluminium layer and in which annealing is provided, characterised in that, after the application of the silicon layer, the components are annealed at a temperature of 480 °C to 570 °C in the case of a silicon layer thickness of more than 0.1 μm, and at a temperature of 400 °C to 500 °C in the case of a silicon layer thickness up to 0.1 μm, and, in the case of a silicon layer thickness of less than 0.05 μm, the annealing process is omitted.

2. A method as claimed in Claim 1, characterised in that in the case of a layer thickness of more than 0.1 μm the components are annealed at a temperature of 500 to 550 °C.

3. A method as claimed in Claim 1 or Claim 2, characterised in that in the case of a silicon layer thickness up to 0.1 μm the components are annealed at a temperature of 420 to 480 °C.

4. A method as claimed in one of Claims 1 to 3, characterised in that the annealing time is set in the range of between 10 minutes and 2 hours.

5. A method as claimed in one of Claims 1 to 4, characterised in that the annealing process is carried out in an inert or reducing atmosphere.

6. A method as claimed in one of Claims 1 to 5, characterised in that the silicon layer is applied by vapour deposition, or sputtering.

7. A method as claimed in one of Claims 1 to 6, characterised in that a polycrystalline silicon layer is provided.

**Revendications**

1. Procédé pour préparer l'établissement ultérieur d'un contact pour des composants au silicium pourvus d'une aluminisation, dans lesquels au moins une couche de silicium est déposée sur l'aluminisation et dans lesquels un traitement thermique est prévu, caractérisé par le fait que les composants sont traités thermiquement, après le dépôt de la couche de silicium, à une température de 480 °C à 570 °C dans le cas d'une couche de silicium ayant une épaisseur supérieure à 0,1 μm, à une température de 400 °C à 500 °C dans le cas d'une couche de silicium ayant une épaisseur allant jusqu'à 0,1 μm, alors que le processus de traitement thermique n'a pas lieu dans le cas où la couche de silicium a une épaisseur inférieure à 0,05 μm.

2. Procédé selon la revendication 1, caractérisé par le fait que les composants sont soumis à un traitement thermique à une température de 500 à 550 °C dans le cas d'une épaisseur de couche de plus de 0,1 μm.

3. Procédé selon la revendication 1 ou 2, caractérisé par le fait que les composants sont soumis à un traitement thermique à une température de 420 à 480 °C dans le cas d'une épaisseur de couche allant jusqu'à 0,1 μm.

4. Procédé selon l'une des revendications 1 à 3, caractérisé par le fait que la durée du traitement thermique est réglée dans une plage située entre dix minutes et deux heures.

5. Procédé selon l'une des revendications 1 à 4, caractérisé par le fait que le processus de traitement thermique est réalisé dans une atmosphère inerte ou réductrice.

6. Procédé selon l'une des revendications 1 à 5, caractérisé par le fait que la couche de silicium est déposée par vaporisation ou par pulvérisation.

7. Procédé selon l'une des revendications 1 à 6, caractérisé par le fait que l'on dépose une couche polycristalline de silicium.

## FIG 1

## FIG 2

## FIG 3